# EUROPEAN PATENT APPLICATION

(11) **EP 1 220 593 A2**
(43) Date of publication of application: **03.07.2002**
(21) Application number: 01130480.5
(22) Date of filing: 20.12.2001
(51) Int. Cl.: H05K 7/14, H02G 3/16, H01H 9/10

(54) **Electric connection box**

(30) Priority: 27.12.2000 JP 2000399539
(71) Applicant: Yazaki Corporation, Minato-ku, Tokyo (JP)
(72) Inventor: Nakamura, Tsuyoshi, Yazaki Parts Co., Ltd., Kosai-shi, Shizuoka (JP)
(74) Representative: Grünecker, Kinkeldey, Stockmair & Schwanhäusser Anwaltssozietät

(57) **Abstract**

One common power circuit relay unit (22) is formed by a fuse (269 and a relay (27) associated with this fuse (26), the fuse and the relay being common to vehicles or grades. One common power circuit relay unit (23) is formed by a fuse (33) and a plurality of relays (34) associated with this fuse (33), the fuse and the relays being common to the vehicles or the grades. The relay units (22, 23) are releasably attached to a cover member (24).

## Description

### BACKGROUND OF THE INVENTION

This invention relates to an electric connection box mounted on a vehicle such as an automobile.

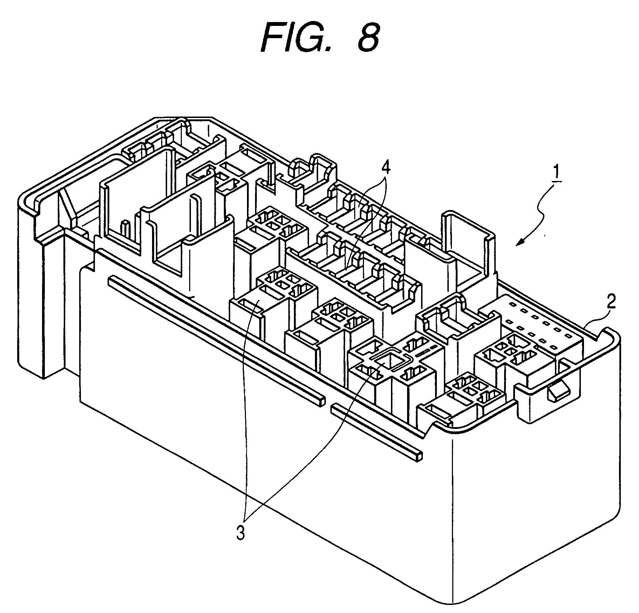

Fig. 8 shows an electric connection box (In this specification, a relay box is shown as an example) to be mounted on a vehicle such as an automobile. The illustrated electric connection box 1 has a plurality of fuse cavities 3, relay cavities 4 and so on provided at a box body 2. Terminals (not shown), each press-connected to an end of a wire, are inserted in the fuse cavities 3 and relay cavities 4, respectively, and these fuse cavities and relay cavities are connected respectively to corresponding fuses and relays (not shown) through the terminals and wires. With this construction, a power circuit is constituted.

In the above related electric connection box, the power circuits to be used in vehicles are different in specification from one another, or the power circuits to be used even in the same kind of vehicle are different in specification from one another according to the grade. Therefore, it is necessary to provide new electric connection boxes each designed for the corresponding vehicle or for the corresponding grade. Namely, the related electric connection box did not have a general-purpose design, and this greatly affected the production cost.

### SUMMARY OF THE INVENTION

This invention has been made under the above circumstances, and an object of the invention is to provide an electric connection box which has a general-purpose design, and contributes to the reduction of a cost.

In order to solve the aforesaid object, the invention is characterized by having the following arrangement.
(1) An electric connection box comprising:
   a common power circuit relay unit for formed by a fuse and at least one relay associated with fuse, the fuse and the at least one relay being common to vehicles or grades,
   a cover member to which one or more kinds of the relay unit are releasably attached.
(2) The electric connection box according to (1), wherein an option attaching portion for an optional power circuit required in accordance with a specification requirement is formed, separately from an attaching portion for the relay units, at the cover member.
(3) The electric connection box according to (2), wherein the cover member is so formed that a plurality of the option attaching portions can be arranged in a juxtaposed manner.
(4) The electric connection box according to (2), wherein a width of the option attaching portion is equal to or an integral multiple of a width of the attaching portion for the relay units .
(5) An electric connection box according to (1), wherein a relay single unit including a single relay is releasably attached to the cover member.
(6) An electric connection box comprising:
   a relay unit, including a relay and a fuse combined together in a packaged manner, and
   a box body to which the relay unit is releasably attached.

According to the invention, one common power circuit relay unit is formed. This relay unit is formed by the fuse and one or more relays associated with the fuse, the fuse and the relays being common to vehicles or grades. One or more kinds of the relay units are provided, and are releasably attached to the cover member. The relay unit itself has the function of a relay box.

According to the invention, the attaching portion and the option attaching portion are formed at the cover member. The relay unit is attached to this attaching portion. An optional power circuit part (unit), required in accordance with a specification requirement, is attached to the option attaching portion.

According to the invention, if necessary, there is formed the cover member having the plurality of option attaching portions arranged in a juxtaposed manner.

According to the invention, the relation between the width of the option attaching portion and the width of the attaching portion becomes clear. In other words, the width of the relay units is standardized.

According to the invention, the relay single unit, comprising the single relay, is further releasably attached to the cover member.

According to the invention, the relay unit, having the relay and the fuse combined together in a packaged manner, is releasably attached to the box body.

### BRIEF DESCRIPTION OF THE DRAWINGS

Fig. 1 is an exploded, perspective view showing one preferred embodiment of an electric connection box of the present invention.
Figs. 2A to 2D are power circuit diagrams of relay units, respectively.
Figs. 3A and 3B are power circuit diagrams of a vehicle A, respectively.
Figs. 4A and 4B are power circuit diagrams of a vehicle B, respectively.
Fig. 5 is a perspective view of a relay single unit.
Fig. 6 is a perspective view of a fuse single unit.
Fig. 7 is an exploded, perspective view of another preferred embodiment of an electric connection box of the invention.
Fig. 8 is a perspective view of a conventional electric connection box.

### DETAILED DESCRIPTION OF PREFERRED EMBODIMENTS

A preferred embodiment of the present invention will now be described with reference to the drawings.

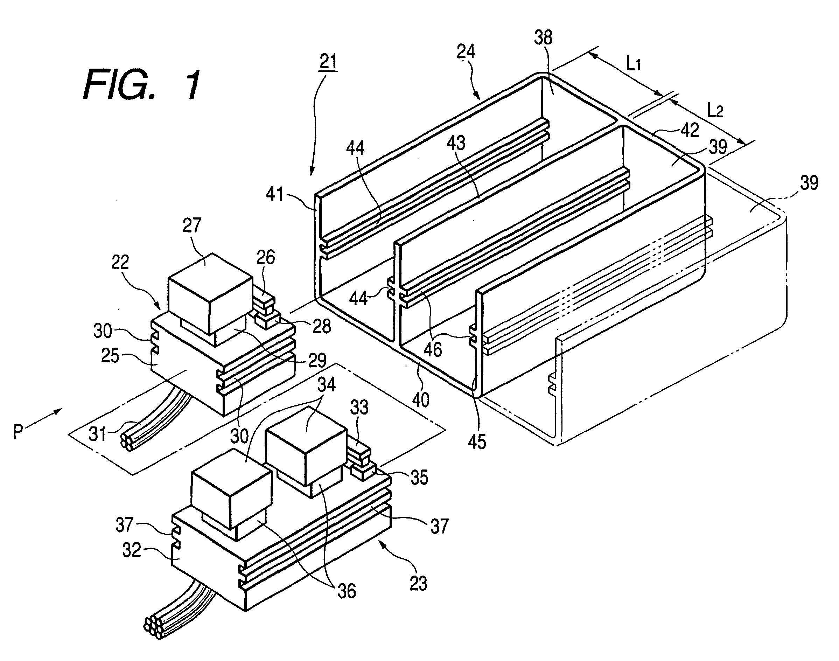

Fig. 1 is an exploded, perspective view of one preferred embodiment of an electric connection box of the invention. Figs . 2A to 2D are power circuit diagrams of relay units, respectively.

In Fig. 1, the electric connection box 21 to be mounted on a vehicle such as an automobile comprises a plurality of relay units 22 and 23, an optional unit (not shown), and a cover member 24 of a synthetic resin for these parts.

First, the component parts will be described. The relay unit 22 comprises a unit casing 25 made of a synthetic resin, a fuse 26 of a known construction, and a relay 27 of a known construction. The unit casing 25 is formed into a rectangular box-like shape with an open bottom. A fuse cavity 28, into which the fuse 26 is inserted, and a relay cavity 29, into which the relay 27 is inserted, are formed integrally on an upper wall of the unit casing 25. Rails 30 and 30 are formed respectively on a pair of right and left walls of the unit casing 25 extending in an attaching direction P (described later). A pair of front and rear walls, disposed perpendicularly to the pair of right and left walls, are flat.

Connection terminals (not shown) for connection to terminals (not shown) of the fuse 26 are inserted into the fuse cavity 28. These connection terminals are inserted into the fuse cavity 28 through the open bottom of the unit casing 25. Ends of wires 31 are press-connected to these connection terminals, respectively.

Connection terminals (not shown) for connection to terminals (not shown) of the relay 27 are inserted in the relay cavity 29. Like the connection terminals for the fuse cavity 28, these connection terminals are inserted into the relay cavity 29 through the open bottom of the unit casing 25. Ends of wires 31 are press-connected to these connection terminals, respectively.

The rails 30 and 30 are parallel to the attaching direction P (described later) . When a pair of grooves are formed in each of the right and left walls, an elongate projection, formed between these grooves, defines the rail 30. Although not particularly shown in the drawings, a retaining projection is formed on each of the rails 30 and 30 (This is not limited to such a projection).

The relay unit 23 comprises a unit casing 32 made of a synthetic resin, a fuse 33 of a known construction, and relays 34 and 34 of a known construction. The unit casing 32 is formed into a rectangular box-like shape with an open bottom. A fuse cavity 35, into which the fuse 33 is inserted, and relay cavities 36 and 36, into which the relays 34 and 34 are inserted, respectively, are formed integrally on an upper wall of the unit casing 32. Rails 37 and 37 are formed respectively on a pair of right and left walls of the unit casing 37 extending in the attaching direction P (described later) . A pair of front and rear walls, disposed perpendicularly to the pair of right and left walls, are flat.

In this embodiment, these right and left walls of the unit casing 37 are twice larger in length than the right and left walls of the unit casing 25. The length (that is, the width) of the front and rear walls of the unit casing 37 is the same as the length (that is, the width) of the front and rear walls of the casing unit 25.

Connection terminals (not shown) for connection to terminals (not shown) of the fuse 33 are inserted into the fuse cavity 35. These connection terminals are inserted into the fuse cavity 35 through the open bottom of the unit casing 32. Ends of wires 31 are press-connected to these connection terminals, respectively.

Connection terminals (not shown) for connection to terminals (not shown) of the corresponding relay 34 are inserted in each of the relay cavities 36 and 36. Like the connection terminals for the fuse cavity 35, these connection terminals are inserted into the relay cavity 36 through the open bottom of the unit casing 32. Ends of wires 31 are press-connected to these connection terminals, respectively.

The rails 37 and 37 are parallel to the attaching direction P (described later) . When a pair of grooves are formed in each of the right and left walls, an elongate projection, formed between these grooves, defines the rail 37. Although not particularly shown in the drawings, a retaining projection is formed on each of the rails 37 and 37 (This is not limited to such a projection).

The fuses 26 and 33 and the relays 27 and 34 are of a known construction, and description of details thereof will be omitted. The above-mentioned optional unit is an optional power circuit, required in accordance with a specification requirement of a vehicle, and is similar in construction to the relay unit 22 or 23 (It comprises a unit casing, a fuse and a relay, or a unit casing and a relay, or a unit casing and a fuse, or the like).

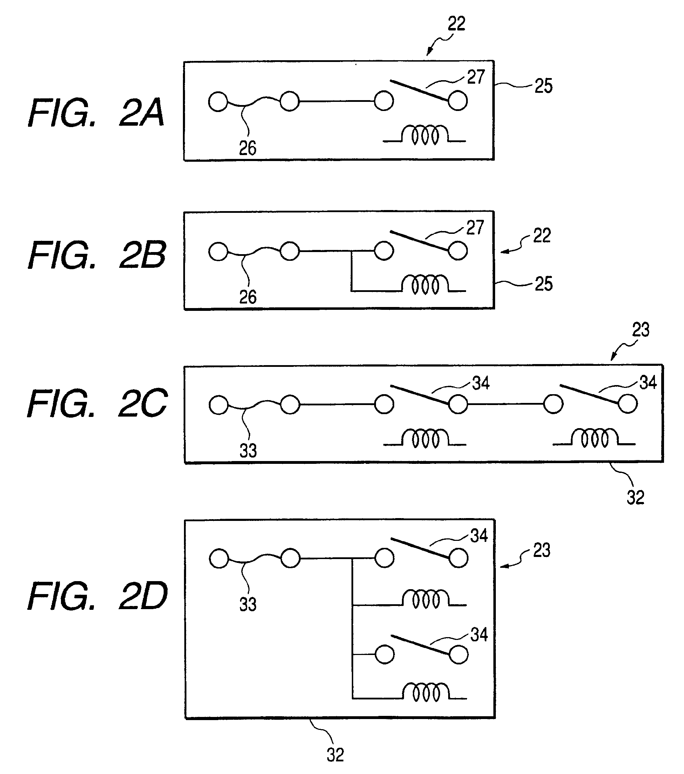

The relay units 22 and 23 will be described in detail. The relay unit 22 is constructed, for example, as shown in Fig. 2A or 2B, and the relay unit 23 is constructed, for example, as shown in Fig. 2C or 2D. Namely, one common power circuit relay unit 22 is constituted by the fuse 26 and the relay 27 associated with this fuse 26. One common power circuit relay unit 23 is constituted by the fuse 33 and the relays 34 and 34 associated with this fuse 33.

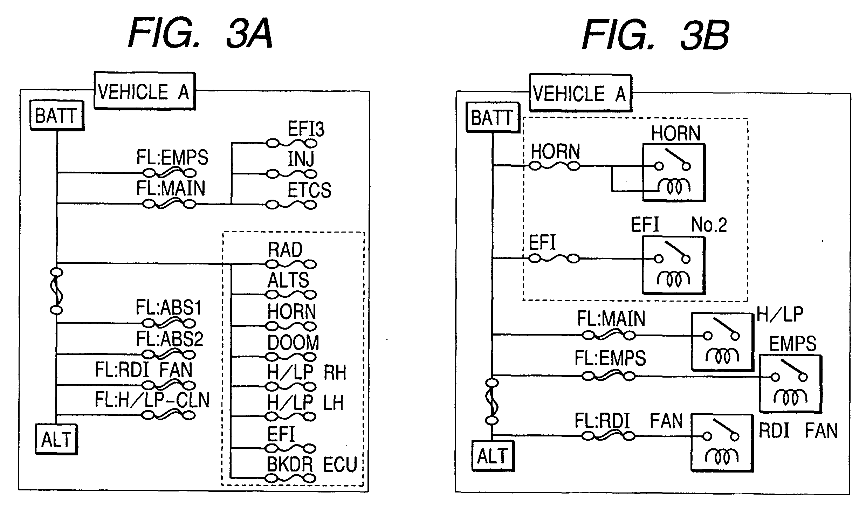

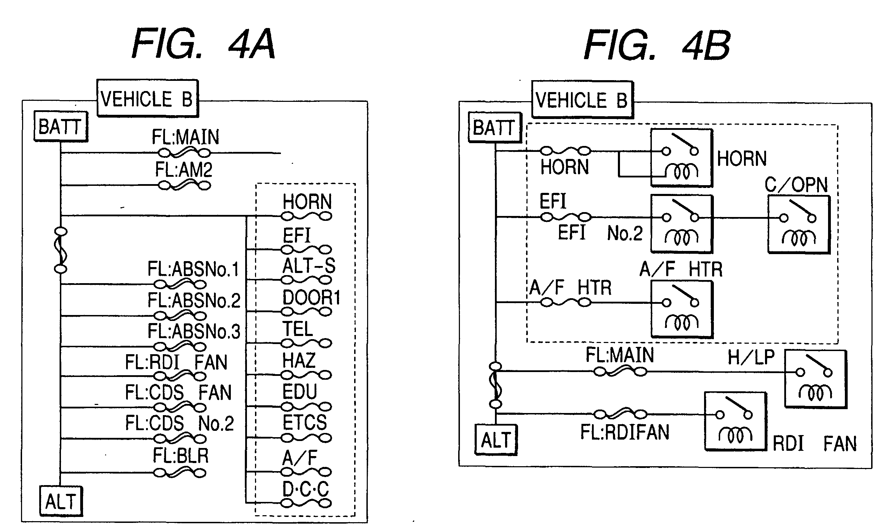

More specifically, with respect to the relay units 22 and 23, fuses and relays, which are common to a vehicle A and a vehicle B as shown in Figs. 3 and 4, are selected, and are provided as units, and these are designed to form the above power circuit (Those fuses and relays, which are common to grades, may be taken out to be provided as units).

Each of the relay units 22 and 23 itself has the function of a relay box.

Referring back to Fig. 1, the cover member 24 includes the attaching portion 38 and an option attaching portion 39, and the relay units 22 and 23 are attached to the attaching portion 38, and the optional unit is attached to the option attaching portion 39.

The attaching portion 38 is a portion formed by a side wall 41, an inner end wall 42 and a partition wall 43 which are provided perpendicularly to a base plate 40 of the cover member 24. The relay units 22 and 23 can be slidably attached to this attaching portion. More specifically, rail sliding grooves 44 and 44 are formed respectively in opposed surfaces of the side wall 41 and the partition wall 43, and the rails 30 and 30 of the relay unit 22, as well as the rails 37 and 37 of the relay unit 23, can slide along these rail sliding grooves.

When a pair of elongate projections are formed on each of the side wall 41 and the partition wall 43, that portion of each of these walls, lying between these elongate projections, defines the rail sliding groove 44. Although not particularly shown in the drawings, a recess, in which the retaining projection is engageable, is formed in each of the rail slide groove portions 44 and 44 (This is not limited to such a recess) .

The option attaching portion 39 is a portion formed by a side wall 45, the inner end wall 42 and the partition wall 43 which are provided perpendicularly to the base plate 40 of the cover member 24 . The optional unit can be slidably attached to this option attaching portion. More specifically, rail sliding grooves 46 and 46 are formed respectively in opposed surfaces of the side wall 45 and the partition wall 43, and rails of the optional unit can slide along these rail sliding grooves. The rail sliding grooves 46 and 46 are formed in the same manner as described above for the rail sliding grooves 44 and 44 of the attaching portion 38.

A plurality of option attaching portions 39 (see imaginary lines in the drawing) can be formed in a juxtaposed manner at the cover member 24 if necessary. This is advantageous from the viewpoint of the cost when many optional units need to be attached.

The width L2 of the option attaching portion 39 is equal to or an integral multiple of the width L1 of the attaching portion 38. With this construction, the relation between the width L2 of the option attaching portion 39 and the width L1 of the attaching portion 38 becomes clear, so that the general-purpose ability can be enhanced. In other words, the width of the relay unit 22 and so on is standardized, so that the general-purpose ability is enhanced (The width L1 of the attaching portion 38 may be determined after the width of the relay unit 22 and so on is standardized).

In the above construction, the relay units 22 and 23 are attached to the attaching portion 38 of the cover member 24, and the optional unit is attached to the option attaching portion 39 of the cover member 24, thereby assembling the electric connection box 21 of the invention. At this time, the relay units 22 and 23, as well as the optional unit, are slid in the attaching direction (indicated by arrow P), and are releasably attached.

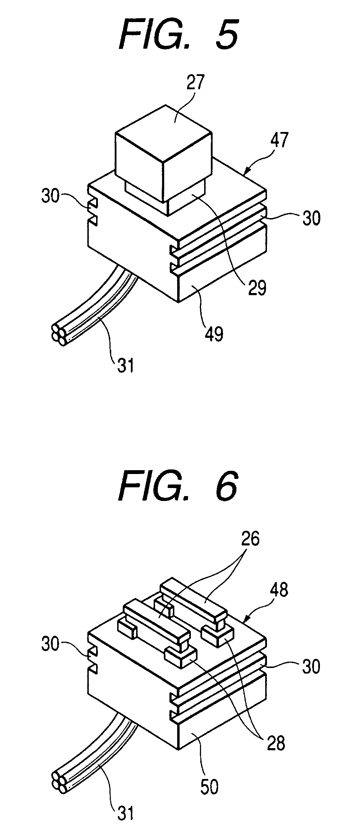

The relay units 22 and 23 are not always attached in a consecutive manner. For example, three relay units 22 may be attached. A relay single unit 47, shown in Fig. 5, and a fuse single unit 48, shown in Fig. 6, may be attached (The relay single unit 47 comprises a unit casing 49, including a relay cavity 29 and rails 30 and 30, and a relay 27. The fuse single unit 48 comprises a unit casing 50, including fuse cavities 28 and 28 and rails 30 and 30, and fuses 26 and 26.). The optional unit may not be attached.

As described above with reference to Figs. 1 to 6, the relay 27 (relays 34) and the fuse 26 (33) are combined together to provide a unit, and these units are releasably attached to the cover member 24. With this construction, the electric connection box 21 can have a general-purpose design. The cost can be reduced because of the general-purpose design of the electric connection box 21. With the above construction, the packaging of a system, provided on the vehicle, can be achieved.

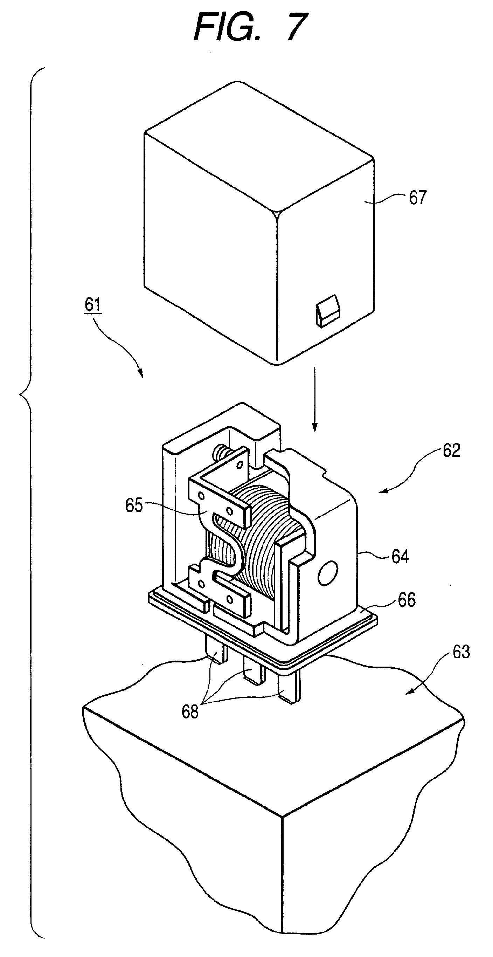

Fig. 7 is an exploded, perspective view of another embodiment of an electric connectionbox of the present invention. The electric connection box 61, shown in Fig. 7, comprises one or more relay units 62, and a box body 63 to which the relay unit(s) 62 is releasably attached.

The relay unit 62 will be described in detail. The relay unit 62 comprises a relay body 64, and a fusible member 65. In other words, a relay and a fuse are combined together in a packaged manner. Namely, the relay unit 62 includes the fusible member 65 contained in the relay body 64 defined by a base plate 66 (of the relay body 64) and an outer cover 67.

Therefore, when the relay unit 62 is connected and attached to the box body 63 through terminals 68 of this relay unit 62, effects, similar to those of the above-mentioned electric connection box 21, are achieved. Namely, the electric connection box 61 can have a general-purpose design since it is provided with the relay unit 62 in which the relay and the fuse are combined together in a packaged manner. And besides, the cost can be reduced because of the general-purpose design of the electric connection box 61. Furthermore, with the above construction, the packaging of a system, providedon the vehicle, can be achieved.

Various modifications of the present invention can be made within the scope of the invention.

As described above, in the invention, the relay and the fuse are combined together as a unit, and this unit is releasably attached to the cover member. With this construction, the electric connection box can have a general-purpose design. And besides, the cost of the electric connection box can be reduced because of its general-purpose design. Furthermore, the packaging of the system, provided on the vehicle, can be achieved.

In the invention, the optional power circuit part (optional unit), required in accordance with a specification requirement, can be attached to the cover member. Therefore, the general-purpose ability is enhanced, so that the cost can be further reduced.

In the invention, the cover member, having the plurality of option attaching portions arranged in a juxtaposed manner, is newly provided if necessary, and this contributes to the reduction of the cost of the electric connection box.

In the invention, the relation between the width of the option attaching portion and the width of the attaching portion is made clear, so that the general-purpose ability is enhanced. In other words, the width of the relay units is standardized, so that the general-purpose ability is enhanced.

In the invention, the relay single unit, comprising the single relay, is further releasably attached to the cover member, so that the general-purpose ability is enhanced.

In the invention, there is provided the relay unit, having the relay and the fuse combined together in a packaged manner, and therefore the electric connection box can have the general-purpose design. And besides, the cost of the electric connection box can be reduced because of its general-purpose design. Furthermore, the packaging of the system, provided on the vehicle, can be achieved.

## Claims

1. An electric connection box comprising:
a common power circuit relay unit for formed by a fuse and at least one relay associated with fuse, the fuse and the at least one relay being common to vehicles or grades,
a cover member to which one or more kinds of the relay unit are releasably attached.

2. The electric connection box according to claim 1, wherein an option attaching portion for an optional power circuit required in accordance with a specification requirement is formed, separately from an attaching portion for the relay units, at the cover member.

3. The electric connection box according to claim 2, wherein the cover member is so formed that a plurality of the option attaching portions can be arranged in a juxtaposed manner.

4. The electric connection box according to claim 2, wherein a width of the option attaching portion is equal to or an integral multiple of a width of the attaching portion for the relay units .

5. An electric connection box according to claim 1, wherein a relay single unit including a single relay is releasably attached to the cover member.

6. An electric connection box comprising:
a relay unit, including a relay and a fuse combined together in a packaged manner, and
a box body to which the relay unit is releasably attached.
